# EUROPEAN PATENT APPLICATION

(11) **EP 1 091 384 A2**
(43) Date of publication of application: **11.04.2001**
(21) Application number: 00302942.8
(22) Date of filing: 07.04.2000
(51) Int. Cl.: H01J 37/153, H01J 37/141, H01J 37/317

(54) **Electron beam imaging apparatus**

(30) Priority: 07.10.1999 US 158267
(71) Applicant: LUCENT TECHNOLOGIES INC., Murray Hill, New Jersey 07974-0636 (US)
(72) Inventor: Katsap, Victor, Belle Mead, New Jersey 08502 (US); Munro, Eric, London SW7 4AN (GB); Rouse, John Andrew, Mitcham, Surrey CR4 2HS (GB); Waskiewicz, Warren K., Clinton, New Jersey 08809 (US); Zhu, Xieqing, London NW2 7JH (GB)
(74) Representative: Williams, David John

(57) **Abstract**

An apparatus for projection lithography is disclosed. The apparatus has at least one magnetic lens. The lens has a segmented magnetic liner therein. The segmented liner has segments of magnetic material alternating with segments of non-magnetic material. The liner is continuous through the lens. The lens and liner both share the same optical axis. The liner is configured to substantially remove the distortions in the magnetic field of the lens. The liner is also configured to provide a magnetic flux density in the lens that is below saturation.

## Description

### PRIORITY APPLICATION INFORMATION

This application claims priority of Provisional Patent Application Serial No. 60/158,267 October 7, 1999 and entitled "Electron Beam Imaging Apparatus."

### BACKGROUND OF THE INVENTION

### Technical Field

The present invention is directed to an electron beam imaging apparatus for use in a lithographic process for device fabrication in which charged particle energy is used to delineate a pattern in an energy sensitive material. The pattern is delineated by projecting the charged particle energy onto a patterned mask, thereby projecting an image of the mask onto the energy sensitive material.

### Art Background

In device processing, an energy sensitive material, denominated a resist, is coated on a substrate such as a semiconductor wafer (e.g., a silicon wafer), a ferroelectric wafer, an insulating wafer, (e.g. a sapphire wafer), a chromium layer supported by a substrate, or a substrate having a combination of such materials. An image of a pattern is introduced into the resist by subjecting the resist to patterned radiation. The image is then developed to produce a patterned resist using expedients such as a solution-based developer or a plasma etch to remove one of either the exposed portion or the unexposed portion of the resist. The developed pattern is then used in subsequent processing, e.g. as a mask to process, i.e. etch, the underlying layer. The resist is then removed. For many devices, subsequent layers are formed and the process is repeated to form overlying patterns in the device.

In recent years, lithographic processes in which a charged particle beam is used to delineate a pattern in an energy sensitive resist material have been developed. Such processes provide high resolution and high throughput. One such process is the SCALPEL® (scattering with angular limitation projection electron beam lithography) process. The SCALPEL® process is described in U.S. Patent No. 5,260,151 which is hereby incorporated by reference.

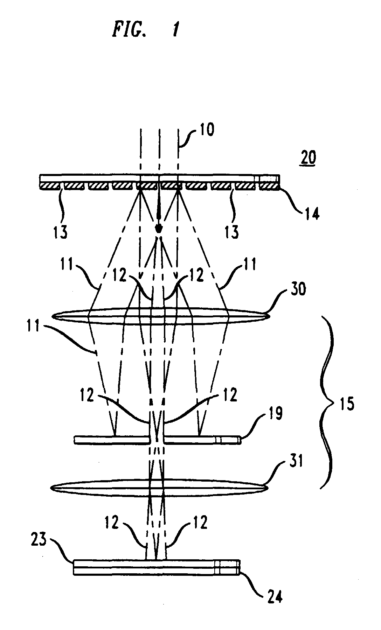

Referring to FIG. 1, a doublet lens system 15 is used in the lithography tool for the SCALPEL® process. A first lens system (not shown) is used to direct and focus incident radiation 10 from the radiation source (not shown) onto the mask 20. The mask 20 is used to pattern particle beam 10. The entire mask 20 is not illuminated at once. Mask 20, as shown, consists of a membrane 13, which is transparent to the particle beams incident thereon, and blocking regions 14.

The developed image of the mask pattern is defined by blocking regions 14, which scatter the particle beams 10 incident thereon. Unblocked illumination, illustrated as beams 12, is transmitted through the membrane regions 13. Blocked illumination, illustrated as beams 11 is caused to converge by means of a first electromagnetic/electrostatic projector lens 30 in lens system 15. Further transmission of beams 11 that emerge from lens 30 is blocked by apertured scatter filter 19. Filter 19 is in the back focal plane of lens system 15. Beams 12 are transmitted through aperture 21 in the back focal plane filter 19.

Second projector lens 31 of lens system 15 is of such configuration and so powered as to bring the unscattered beams 12 into an approximately parallel relationship. The action of the lens 31 is sufficient to direct beams 12 into orthogonal incidence onto wafer 24.

Deflectors (not shown) are provided to avoid imaging unwanted areas of the mask (i.e. to avoid imaging the skirts and struts that provide structural support but do not have pattern information). Deflectors are so energized as to redirect off-axis beams. The deflectors are used to directional control the direction of the beams to avoid imaging the struts and skirts. The deflectors are also used to scan the beam across the mask. Scanning the beam provides faster imaging, which translates into faster throughput.

However, the lens limits the degree to which the beam is scanned. Specifically, scanning the beam into an off-axis relationship with respect to the lens introduces aberrations into the beam. These aberrations can have an adverse effect on the image (i.e. the image is blurred by the aberrations).

A doublet electromagnetic lens arrangement is described in Waskiewicz, W., et al., "Electron-optics method for High-Throughput in a SCALPEL system: preliminary analysis," Microelectronic Engineering, Vol. 41/42, pp. 215-218 (1998). The doublet electromagnetic lens system described in Waskiewicz et al. has the deflectors 20 and 21 inside each lens. The deflectors are used to correct beam shape distortions. That is, the deflectors are used to make the beam more axially symmetric. This arrangement is required in the SCALPEL tool in order to decrease aberrations in the image that result from asymmetry in the beam. That is, if the beam is asymmetric, then the imaging field will also be asymmetric. Asymmetry in the imaging field will introduce aberrations in the image that is introduced into the energy sensitive material.

The magnetic deflectors are made of coils wound on a magnetic core. One skilled in the art is well aware of numerous deflector designs and of the numerous materials from which such magnetic deflectors are made. Typically, magnetic deflectors have a magnetic core made of ferrite or other iron-containing material. Suitable magnetic materials have a magnetic material permeability on the order of about 1000.

However, the placement of the beam steering deflectors inside the lens produces an undesired effect. First, the deflectors distort the magnetic field of the lens. A distortion of the lens' magnetic field translates into a lens aberration, which is not desired.

Another undesired consequence of the lens design described in Waskiewicz et al. is the eddy currents in the magnetic field that naturally occur in the magnetic lens when the deflectors are present. These eddy currents in the magnetic field cause undesired beam fluctuations and also defocus the beam. Accordingly, a lens design that addresses these undesired effects and a lithography tool with such a lens design is sought.

### SUMMARY OF INVENTION

The present invention is directed to a magnetic lens with a segmented liner therein. The segmented magnetic liner extends continuously through the lens. The segmented liner is alternating bands of magnetic and non-magnetic material. In one embodiment, the segmented liner has ferrite rings alternating with rings of a dielectric material. The segmented liner, if mechanically coupled to the lens, is coupled using a dielectric material. In another embodiment, the segmented is not mechanically coupled to the lens, but is supported in the lens by a separate structure.

The liner is configured so that the magnetic field of the lens coupled to the liner, is effectively distortion-free. Distortions in a magnetic field are well known to one skilled in the art. Such distortion, caused by eddy currents in the magnetic lens shell, lead to electromagnetic field fluctuations along the beam path through the lens. Such fluctuations are undesirable because they introduce aberrations into the image transmitted by the lens. Thus, eliminating the distortions in the magnetic field eliminates aberrations in the image associated with such distortions. However, the liner is configured to avoid causing the magnetic flux density to saturate the lens shell. One skilled in the art is aware that magnetic flux from a magnetic lens must be below saturation. One skilled in the art is also aware that the magnetic flux divided by the lens shell cross-section equals the magnetic flux density. If the magnetic flux exceeds saturation, distortions are reintroduced into the magnetic field. Consequently, the liner is configured to maintain the magnetic flux below saturation. In a further embodiment, deflectors are incorporated into the magnetic liner.

The present invention is also directed to a magnetic doublet lens system in which each magnetic lens is equipped with a segmented magnetic liner. The present invention is also directed to an apparatus for electron beam lithography that has a magnetic doublet lens system. The magnetic doublet lens is equipped with a segmented magnetic liner that reduces lens aberrations caused by deflectors and eddy currents within the magnetic lens.

### BRIEF DESCRIPTION OF THE DRAWINGS

FIG. 1 is a schematic representation of an electron beam lithography tool.
FIG. 2 is a schematic cross-section of a magnetic lens with a magnetic liner that reduces perturbations in the magnetic field of the lens.
FIG. 3 is a schematic cross-section of a magnetic lens and the magnetic field inside the lens.
FIG. 4 is a schematic of an embodiment of the magnetic lens system of the present invention in which deflectors are incorporated into the liner.

### DETAILED DESCRIPTION

In the present invention, a segmented liner is inserted into a magnetic lens. The segmented liner has bands of magnetic material alternating with bands of non-magnetic material. In one embodiment, the segmented liner is a series of stacked rings, alternating between a ring of ferrite and a ring of a dielectric material. The segmented liner is centered about the optical axis of the lens. Consequently, the optical axis of the lens is also the axis of the segmented liner.

In one embodiment, the magnetic liner is inserted in each of the two individual lenses in a magnetic doublet lens system. In this embodiment, the doublet lens system is placed in an electron beam lithography tool. A back focal plane filter is inserted in an essentially field-free space between the two magnetic lenses. In a further embodiment, magnetic clamps affixed to each lens in the magnetic lens system provide the essentially field-free space.

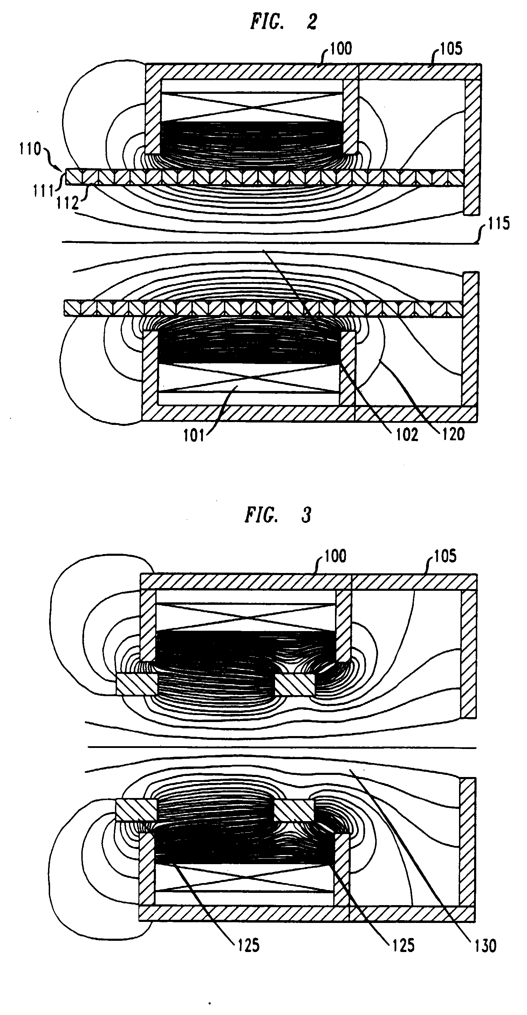

A schematic of one embodiment of the present invention is illustrated in FIG. 2. FIG. 2 illustrates one magnetic lens 100. Although depicted as a single lens, one skilled in the art will appreciate that such a lens is also used in a magnetic lens doublet system. Lens 100 is equipped with magnetic clamp 105. Magnetic clamp 105 is made of a magnetic material, such as soft iron or ferrite.

The magnetic lens 100 has a continuous magnetic liner, 110, disposed therein. The magnetic lens has windings 101 and core 102. The magnetic liner 110 is continuous through the entire length of lens 100. The length of the lens is also referred to as the length of the gap, the gap being the distance defined by the core in the direction of the optical axis 115.

The magnetic liner 110 is centered on the optical axis 115 of the lens 100. The magnetic liner 110 is a series of magnetic rings 111 alternating with another series of non-magnetic rings 112. In the context of the present invention, a non-magnetic material is a material with a magnetic permeability close to 1. It is advantageous if the magnetic ring material has a magnetic permeability of at least about 600 units. It is also advantageous if the magnetic material has an electrical resistance greater than 100 ohm-cm. In one embodiment, the magnetic rings are ferrite rings and the non-magnetic rings are a dielectric material such as, for example, silica.

Air is also envisioned as a suitable dielectric material. Consequently, the magnetic liner is also embodied by a structure which has bands of ferrite material. The bands of ferrite material are separated by a support structure of an electrically insulating (i.e. an electrical resistance higher than about 1000 ohm-cm) material. It is advantageous if the support structure is non-magnetic material. Examples of suitable support structure materials include glass and ceramics. The ferrite segments are mounted on the support structure such that there are gaps between the ferrite segments. These gaps (and the air that fills the gaps) function as the intervening dielectric material.

Within these constraints, the size and spacing of the ferrite segments is largely a matter of design choice. For example, if the ferrite liner, and the lens in which the liner is placed, have cylindrical configurations, then the ratio of the outer diameter of the liner to the inner diameter of the lens should be less than one, but greater than about 0.6. In this embodiment, the ratio of the inner diameter of the ferrite ring to the outer diameter of the ferrite ring is in the range of about 0.45 to about 0.85. The ratio of the thickness of the ferrite rings to the width of the spacing between rings is in the range of about 0.4 to about 2.

The magnetic field 120 that is generated by the lens 100 is also illustrated. The magnetic field 120 in the region of the optical axis 110 is uniform and free of eddy currents or other non-uniformities that would be a source for aberrations. The effect of the magnetic liner is illustrated by referring to FIG. 3. FIG. 3 illustrates the same lens system as in FIG. 2, but with non-continuous ferro-magnetic deflectors 125, instead of a liner. The magnetic field 130 of such a lens has many more irregularities (including those caused by eddy currents) than the field generated by the lens illustrated in FIG. 2.

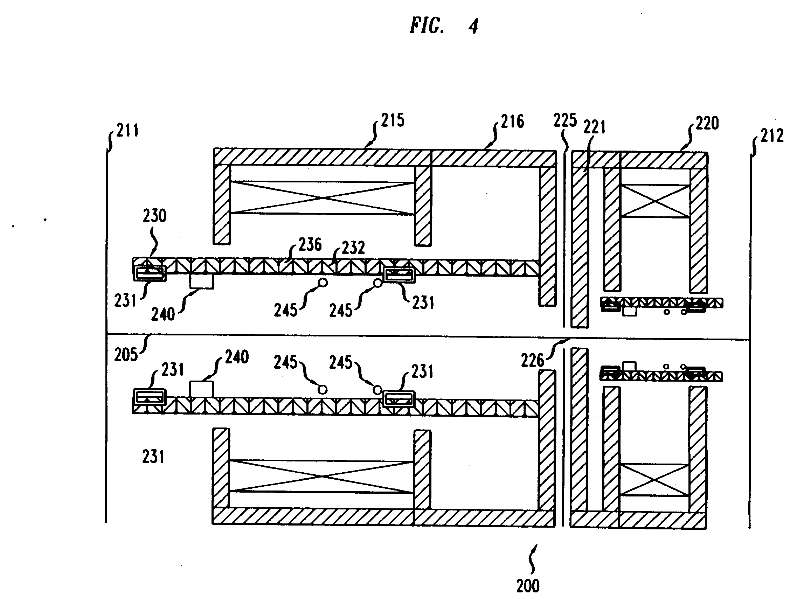

A second embodiment of the present invention is described with reference to FIG. 4. FIG. 4 is a schematic cross-section of a magnetic doublet lens system placed in an electron beam lithography tool. The doublet lens 200 has an optical axis 205. The magnetic doublet lens system 200 has a first lens 215 and a second lens 220. The magnetic doublet lens system 200 is placed between the mask plane 211 and the image plane 212.

Lens system 200 is also equipped with magnetic liners 230 and 235. Magnetic liners 230 and 235 are both centered around optical axis 205. Magnetic liner 230 extends through the entire length of lens 215 and magnetic liner 235 extends through the entire length of lens 220. Magnetic liners 230 and 235 are both a series of rings of magnetic material that alternate with rings of a dielectric material. This is more clearly observed referring to magnetic liner 230 (because liner 235 is one-fourth the size of liner 230 due to the fact that the lens system 200 is a 4:1 reduction or demagnification lens system). The rings of magnetic material are designated as 236. The rings of non-magnetic material are designated as 237.

Deflectors 231 are incorporated into magnetic liner 230. The deflectors 231 do not extend through the entire thickness of the magnetic liner 230, thus preserving the continuity of the pattern of alternating layers.

The lens system 210 is also equipped with stigmators 240 and dynamic focus coils 245. There is one stigmator 240 and two dynamic focus coils 245 for lens 215. There is also one stigmator 240 and two dynamic focus coils 245 for lens 220. The stigmators 240 and the dynamic focus coils 245 compensate for off-axis and axial astigmatism and field curvature, thus keeping e-beam profile shape symmetric about its axis.

The magnetic doublet lens system illustrated in FIG. 4 is also equipped with magnetic clamps. First lens 215 is coupled to a first magnetic clamp 216. Second lens 220 is coupled to a second magnetic clamp 221. An apertured scatter filter 225 is placed between the first magnetic clamp 216 and the second magnetic clamp 221. The aperture 226 in the apertured scatter filter 225 is centered about the optical axis 205 of the lens system 200. The magnetic clamps are provided to confine the magnetic fields from lenses 215 and 225 so that the fields from these two lenses do not substantially overlap. Such clamps are not required in lens/linear assembly of the present invention. However, in the embodiment of the present invention wherein the lens is a magnetic lens doublet system, it is advantageous if the lens system is equipped with the magnetic liner and the magnetic clamps.

The size and configuration of the magnetic clamps 216 and 221 are determined by a number of factors. For example, the magnetic clamps are designed to prevent the fields from lenses 215 and 220 from substantially penetrating into the region in which the apertured scatter filter 225 is placed. Also, the magnetic clamps are configured so as not to interfere with the radiation transmitted through the lens system. Further, the magnetic clamps must be sized to preserve the symmetry of each peak in the magnetic doublet of the lens system 200. As one skilled in the art is aware, a magnetic doublet lens system provides a curve of magnetic flux as a function of distance on the optical axis that consists of two peaks. One peak is the inverse of the other. Each lens is associated with one peak. The peak of the curve corresponds to that position on the optical axis where the midpoint of the lens is located. The desired symmetry is obtained when the first half of one peak is the mirror image of its second half. This relationship is well known by one skilled in the art.

The lens system 210 is configured to demagnify an image of a mask (not shown) in the mask plane 211. The degree of demagnification is 0.25 (i.e., an image reduction of 4:1). The demagnified image is transmitted into an energy sensitive material (not shown), which is in the wafer plane 212. The lens system 200 is centered about the optical axis 205.

The actual dimensions of the lens system 200 is largely a matter of design choice. However, in order for the lens system to provide a desired magnification or demagnification, certain dimensional relationships between the first lens 215 (and its associated components) and the second lens 220 (and its associated components) are required. For example, for lens system 200 to provide a 4:1 demagnification, there is a 4:1 relationship between certain dimensions of first lens 215 and second lens 220.

In a specific example, the distance between the mask plane 211 and the apertured scatter filter 225 is 320 mm. The distance between the image plane 212 and the apertured scatter filter is 80 mm. The distance between the magnetic clamp 216 and the apertured scatter filter 225 is 10 mm and the distance between the magnetic clamp 221 and the apertured scatter filter is 2.5 mm.

Although the present invention has been described in terms of numerous examples, one skilled in the art will appreciate that numerous other embodiments are within the scope of the following claims. Consequently, the preceding examples should not be construed as limiting the present invention in any way, except in a manner that is consistent with the following claims.

## Claims

1. A magnetic lens assembly comprising:
a magnetic lens coupled to a magnetic liner positioned within the magnetic lens, wherein the magnetic liner extends continuously through the lens and wherein the magnetic liner and the magnetic lens have a common optical axis, the magnetic liner comprising a plurality of segments of a magnetic material, wherein adjacent segments are separated by a non-magnetic material.

2. The assembly of claim 1 wherein the magnetic material has a magnetic permeability of at least about 600 units.

3. The assembly of claim 2 wherein the magnetic material has an electrical resistance that is greater than about 100 ohm-cm.

4. The assembly of claim 1 wherein the magnetic liner further comprises a support structure, wherein the segments of magnetic material are spaced apart from each other on the support structure, and wherein the support structure is a non-magnetic material.

5. The assembly of claim 1 wherein the non-magnetic material is air between the adjacent segments.

6. The assembly of claim 1 wherein the magnetic lens and the magnetic liner have a cylindrical configuration having an inner diameter and an outer diameter, wherein the ratio of the outer diameter of the magnetic liner to the inner diameter of the magnetic lens is less than about one but greater than about 0.6.

7. The assembly of claim 6 wherein the ratio of the inner diameter of the magnetic liner to the outer diameter of the magnetic liner is about 0.45 to about 0.85.

8. The assembly of claim 7 wherein the magnetic segments have a thickness and wherein the ratio of the thickness of the magnetic segments to the space between segments is about 0.4 to about 2.

9. The assembly of claim 1 wherein the magnetic lens assembly is a magnetic doublet lens.

10. The assembly of claim 9 wherein the magnetic doublet lens assembly has a first lens coupled to a first magnetic liner and a second lens assembly coupled to a second magnetic liner and wherein the magnetic doublet lens assembly is configured to provide either image demagnification or image magnification, and wherein there is a first ratio between dimensions of the first lens and dimensions of the second lens that corresponds to the image demagnification or magnification and a second ratio between dimensions of the first magnetic liner and the second magnetic liner and wherein the first ratio and the second ratio are the same.

11. An apparatus for projection lithography comprising:
a magnetic doublet lens assembly and a back focal plane filter positioned in the back focal plane or some equivalent conjugate plane of the magnetic doublet lens assembly, the back focal plane filter having a first aperture which is adapted to transmit insignificantly scattered radiation from a radiation source therethrough wherein each magnetic doublet lens system has two magnetic lenses, each coupled to a magnetic liner positioned within the magnetic lens, wherein the magnetic liner extends continuously through the magnetic lens and wherein the magnetic liner and the magnetic lens have a common optical axis, the magnetic liner comprising a plurality of segments of a magnetic material, wherein adjacent segments are separated by a non-magnetic material.

12. The apparatus of claim 11 further comprising a pair of ferromagnetic clamps, a first clamp associated with the first lens in the magnetic doublet lens assembly and a second clamp associated with the second lens in the magnetic lens assembly, wherein the first clamp and the second clamp are configured to substantially separate the magnetic field from the first lens from the magnetic field of the second lens.

13. The apparatus of claim 12 wherein the back focal plane filter is placed between the two lenses of the magnetic doublet lens and wherein the clamps are placed and configured to prevent the magnetic fields of the first and second lens from extending to the back focal plane filter.

14. The apparatus of claim 13 wherein the magnetic material is a ferromagnetic material.

15. The apparatus of claim 11 wherein the magnetic material has a magnetic permeability of at least about 600 units.

16. The apparatus of claim 15 wherein the magnetic material has an electrical resistance that is greater than about 100 ohm-cm.

17. The apparatus of claim 11 wherein the magnetic liner further comprises a support structure, wherein the segments of magnetic material are spaced apart from each other on the support structure, and wherein the support structure is a non-magnetic material.

18. The apparatus of claim 11 wherein the non-magnetic material is air between the spaced apart segments.

19. The apparatus of claim 11 wherein the magnetic lens and the magnetic liner have a cylindrical configuration having an inner diameter and an outer diameter, wherein the ratio of the outer diameter of the magnetic liner to the inner diameter of the magnetic lens is less than about one but greater than about 0.6.

20. The apparatus of claim 19 wherein the ratio of the inner diameter of the magnetic liner to the outer diameter of the magnetic liner is about 0.45 to about 0.85.

21. The apparatus of claim 20 wherein the magnetic segments have a thickness and wherein the ratio of the thickness of the magnetic segments to the space between segments is about 0.4 to about 2.

22. The apparatus of claim 11 wherein the magnetic lens assembly is a magnetic doublet lens.

23. The apparatus of claim 22 wherein the magnetic doublet lens assembly has a first lens coupled to a first magnetic liner and a second lens assembly coupled to a second magnetic liner and wherein the magnetic doublet lens assembly is configured to provide either image demagnification or image magnification, and wherein there is a first ratio between dimensions of the first lens and dimensions of the second lens that corresponds to the image demagnification or magnification and a second ratio between dimensions of the first magnetic liner and the second magnetic liner and wherein the first ratio and the second ratio are the same.
